(19) Europäisches Patentamt
European Patent Office
Office européen des brevets

(11) **EP 3 988 951 B1**

(12) **EUROPÄISCHE PATENTSCHRIFT**

(45) Veröffentlichungstag und Bekanntmachung des Hinweises auf die Patenterteilung:
**22.02.2023 Patentblatt 2023/08**

(21) Anmeldenummer: **21202351.9**

(22) Anmeldetag: **13.10.2021**

(51) Internationale Patentklassifikation (IPC):
*G01R 31/00* (2006.01)    *G01R 31/36* (2006.01)
*H01M 10/42* (2006.01)    *H01M 8/04537* (2016.01)
*H01M 8/2475* (2016.01)    *H01M 10/48* (2006.01)
*H01M 16/00* (2006.01)    *H01M 50/204* (2021.01)
*H01M 50/231* (2021.01)    *H01M 50/233* (2021.01)
*H01M 50/249* (2021.01)

(52) Gemeinsame Patentklassifikation (CPC):
G01R 31/008; G01R 31/3644; H01M 8/04634;
H01M 8/2475; H01M 10/48; H01M 16/006;
H01M 50/204; H01M 50/231; H01M 50/233;
H01M 50/249; H01M 10/482; H01M 2220/20;
Y02E 60/10; Y02E 60/50

(54) **ANORDNUNG MIT EINEM SPANNUNGSMODUL**

ARRANGEMENT WITH A TENSION MODULE

AGENCEMENT DOTÉ D'UN MODULE DE SERRAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.10.2020 DE 102020213019**

(43) Veröffentlichungstag der Anmeldung:
**27.04.2022 Patentblatt 2022/17**

(73) Patentinhaber: **Siemens Mobility GmbH 81739 München (DE)**

(72) Erfinder:
• **Glinka, Martin**
  **91054 Buckenhof (DE)**
• **Jaumann, Tony**
  **90419 Nürnberg (DE)**
• **Kunst, Dietmar**
  **38667 Bad Harzburg (DE)**
• **Schmid, Robert**
  **91336 Heroldsbach (DE)**

(56) Entgegenhaltungen:
EP-A1- 2 685 541        CN-A- 103 048 376
DE-A1-102014 221 392

**Beschreibung**

Die Erfindung bezieht sich unter anderem auf eine Anordnung mit einem Gehäuse und zumindest einem in dem Gehäuse befindlichen Spannungsmodul.

Im Bereich der Schienenfahrzeug- bzw. Eisenbahntechnik werden zukünftig vermehrt Schienenfahrzeuge mit Spannungsmodulen, die Batterien als Energiespeicher und/oder Brennstoffzellen als Energiequelle enthalten können, ausgestattet.

Der Einsatz von Spannungsmodulen der beschriebenen Art in Schienenfahrzeugen erfordert eine lange Lebensdauer, um Tauschkosten, die unter Umständen bis zu 20 % der Kosten der Schienenfahrzeuge ausmachen können, und kostenintensive Wartungseinsätze, welche insbesondere beim Bahnverkehr äußerst kostspielig sein können, zu vermeiden.

Die Lebensdauer der Spannungsmodule hängt nicht nur von dem Zustand der darin enthaltenen Zellen ab, sondern unter anderem auch von der Isolierung, da die Gefahr elektrischer Schläge oder eines Kurzschlusses oder Brandes zu minimieren ist. Da die Isolierung über die Lebensdauer von bis zu 15 Jahren Vibrationen, Feuchtigkeit und Temperaturschwankungen standhalten soll, werden bei der Fertigung besonders hohe Anforderungen gestellt. Relevanter Stand der Technik findet sich in den Dokumenten DE102014221392, CN103048376 und EP2685541.

Der Erfindung liegt die Aufgabe zugrunde, eine Anordnung mit einem Spannungsmodul anzugeben, die einen besonders sicheren Betrieb und eine Kontrolle der Isolierung des Spannungsmoduls nach der Fertigung, vorzugsweise auch während des späteren Betriebs, beispielsweise während der Fahrt eines mit der Anordnung ausgestatteten Fahrzeugs, in besonders einfacher Weise erlaubt.

Diese Aufgabe wird erfindungsgemäß durch eine Anordnung mit den Merkmalen gemäß Patentanspruch 1 gelöst. Vorteilhafte Ausgestaltungen der erfindungsgemäßen Anordnung sind in Unteransprüchen angegeben.

Danach ist erfindungsgemäß vorgesehen, dass das Spannungsmodul eine innere Isolationsschicht und eine äußere Isolationsschicht aufweist, die eine oder mehrere in dem Spannungsmodul enthaltene Zellen von dem Gehäuse elektrisch isolieren, wobei zwischen der inneren und der äußeren Isolationsschicht eine elektrisch leitfähige moduleigene Zwischenschicht angeordnet ist, die Anordnung eine Schalteinrichtung aufweist, die im Prüfbetrieb die moduleigene Zwischenschicht wahlweise mit dem Gehäuse oder einem Spannungsanschluss, insbesondere dem Plus- oder Minuspol des Spannungsmoduls oder einer das Spannungsmodul enthaltenden elektrischen Einrichtung, verbinden kann, die Anordnung eine Steuereinrichtung aufweist, die mittels der Schalteinrichtung zum Überprüfen der inneren Isolationsschicht die moduleigene Zwischenschicht mit dem Gehäuse und zum Überprüfen der äußeren Isolationsschicht die moduleigene Zwischenschicht mit dem Spannungsanschluss verbindet, eine Messeinrichtung vorhanden ist, die während des Überprüfens der inneren oder äußeren Isolationsschicht zumindest einen Messwert erfasst und die Steuereinrichtung den zumindest einen Messwert auswertet und ein Fehlersignal erzeugt, wenn die Auswertung auf einen Fehler der Isolation der zu überprüfenden Isolationsschicht hinweist.

Ein wesentlicher Vorteil der erfindungsgemäßen Anordnung ist darin zu sehen, dass das oder die Spannungsmodule jeweils durch zumindest zwei Isolationsschichten isoliert sind, sodass die Gefahr eines Komplettausfalls der Isolation - verglichen mit Spannungsmodulen, die nur eine einzige Isolationsschicht aufweisen - deutlich reduziert ist.

Ein weiterer wesentlicher Vorteil der erfindungsgemäßen Anordnung besteht darin, dass die inneren und äußeren Isolationsschichten durch die erfindungsgemäß vorgesehenen, elektrisch leitfähigen moduleigenen Zwischenschichten in Kombination mit der erfindungsgemäß vorgesehenen Schalteinrichtung jeweils individuell charakterisiert, insbesondere auf eine ausreichende Isolationswirkung bzw. das Vorliegen eines ausreichend großen Isolationswiderstands geprüft werden können. Wird dabei festgestellt, dass eine der Isolationsschichten nicht mehr ausreichend isoliert, so können die betroffenen Spannungsmodule oder die gesamte elektrische Einrichtung, in der die Spannungsmodule enthalten sind, außer Betrieb genommen werden, noch bevor die jeweils andere der zumindest zwei Isolationsschichten des betroffenen Spannungsmoduls ebenfalls ausfällt.

Ein zusätzlicher wesentlicher Vorteil der erfindungsgemäßen Anordnung ist darin zu sehen, dass diese eine Überwachung der Isolierung des oder der Spannungsmodule auch während des späteren Betriebs bzw. Einsatzes des bzw. der Spannungsmodule ermöglicht, beispielsweise während der Fahrt im Falle eines Einsatzes der Anordnung innerhalb eines Fahrzeugs.

Die Spannungsmodule bilden vorzugsweise eine elektrische Einrichtung, deren Pluspol und Minuspol gegenüber dem Gehäuse isoliert sind.

Vorteilhaft ist es, wenn die Steuereinrichtung den zumindest einen Messwert der Messeinrichtung oder zumindest einen daraus abgeleiteten Wert auf das Einhalten zumindest eines vorgegebenen Grenzwertes hin überwacht und ein Fehlersignal erzeugt, wenn der zumindest eine Messwert oder der zumindest eine abgeleitete Wert den zumindest einen vorgegebenen Grenzwert nicht einhält.

Bei einer als besonders vorteilhaft angesehenen Ausführungsform ist vorgesehen, dass in dem Gehäuse zwei oder mehr Spannungsmodule enthalten sind, die jeweils durch eine innere Isolationsschicht und eine äußere Isolationsschicht von dem Gehäuse elektrisch isoliert sind, wobei zwischen der inneren und der äußeren Isolationsschicht jeweils eine elektrisch leitfähige moduleigene Zwischenschicht angeordnet ist, die Schalteinrichtung die moduleigenen Zwischenschichten der Spannungsmodule jeweils wahlweise mit dem Gehäuse oder dem Spannungsanschluss verbinden kann, und die Steuereinrichtung die Isolationsschicht jedes der Spannungsmodule individuell überprüfen kann und zum Überprüfen der inneren Isolationsschicht eines zur Prüfung ausgewählten Spannungsmoduls mittels der Schalteinrichtung die moduleigene Zwischenschicht des jeweiligen Spannungsmoduls mit dem Gehäuse und zum Überprüfen der äußeren Isolationsschicht des jeweiligen Spannungsmoduls mittels der Schalteinrichtung jeweils die moduleigene Zwischenschicht des jeweiligen Spannungsmoduls mit dem Spannungsanschluss verbindet.

Wenn in dem Gehäuse zwei oder mehr Spannungsmodule enthalten sind, die Bestandteile einer elektrischen Einrichtung bilden, ist es vorteilhaft, wenn das Gehäuse auf einem Bezugspotential liegt und die Potentiale eines Pluspols und eines Minuspols der elektrischen Einrichtung bezüglich des Bezugspotentials mittels einer äußeren Beschaltung festgelegt sind.

Bei der letztgenannten Variante wird es als vorteilhaft angesehen, wenn die Messeinrichtung einen Spannungsmesswert, der die Spannung zwischen dem Gehäuse und einem Plus- oder Minuspol der elektrischen Einrichtung angibt, misst und die Steuereinrichtung ein Warnsignal erzeugt, wenn der Spannungsmesswert betragsmäßig eine vorgegebene untere Grenze, insbesondere einen Betrag von 20 % der zwischen dem Plus- und Minuspol der elektrischen Einrichtung anliegenden Gesamtspannung, unterschreitet oder eine vorgegebene obere Grenze, insbesondere einen Betrag von 80 % der zwischen dem Plus- und Minuspol der elektrischen Einrichtung anliegenden Gesamtspannung, überschreitet.

Die Messeinrichtung ist vorzugsweise eine aktive Messeinrichtung, die zum Überprüfen der inneren oder äußeren Isolationsschicht eine Wechselspannung, insbesondere im zeitlichen Verlauf rechteckförmige Wechselspannung, an die jeweilige mittels der Schalteinrichtung zur Prüfung ausgewählte Isolationsschicht anlegt und als Messwert einen Strommesswert, der den Strom durch die Isolationsschicht angibt, oder einen Widerstandsmesswert, der den Widerstand der Isolationsschicht angibt, erzeugt.

Die Messeinrichtung kann in vorteilhafter Weise durch einen Isolationswächter gebildet sein oder einen solchen auch umfassen.

Die Schalteinrichtung umfasst vorzugsweise eine einen ersten Schalter und einen zweiten Schalter aufweisende Reihenschaltung, die elektrisch zwischen das Gehäuse oder den Spannungsanschluss geschaltet ist und einen Mittenanschluss aufweist.

Jede der moduleigenen Zwischenschichten ist vorzugsweise jeweils mittels eines schichteigenen Schalters an den Mittenanschluss angeschlossen.

Die Reihenschaltung weist vorzugsweise einen ersten Vorwiderstand und einen zweiten Vorwiderstand auf.

Zwischen den Mittenanschluss und den Spannungsanschluss ist vorzugsweise der erste Vorwiderstand und zwischen den Mittenanschluss und das Gehäuse der zweite Vorwiderstand geschaltet.

Der erste und zweite Vorwiderstand weisen vorzugsweise Widerstandswerte zwischen 1 kΩ und 100 kΩ auf.

Die Steuereinrichtung ist vorzugsweise dazu ausgebildet, zum Überprüfen der inneren Isolationsschicht eines der Spannungsmodule den ersten Schalter und den schichteigenen Schalter des jeweiligen Spannungsmoduls zu schließen und den zweiten Schalter zu öffnen oder geöffnet zu lassen und zum Überprüfen der äußeren Isolationsschicht eines der Spannungsmodule den zweiten Schalter und den schichteigenen Schalter des jeweiligen Spannungsmoduls zu schließen und den ersten Schalter zu öffnen oder geöffnet zu lassen.

Auch kann in vorteilhafter Weise vorgesehen sein, dass das oder die Spannungsmodule zusätzlich zu der inneren Isolationsschicht und der äußeren Isolationsschicht jeweils weitere Isolationsschichten und weitere leitfähige moduleigene Zwischenschichten aufweist und die Schalteinrichtung eine Vielzahl an Schaltern aufweist, die eine individuelle Auswahl jeder einzelnen der Isolationsschichten eines jeden der Spannungsmodule zum Zwecke des Überprüfens der jeweiligen Isolationsschicht mit Hilfe der Messeinrichtung ermöglichen.

Die elektrische Einrichtung kann in vorteilhafter Weise als Spannungsmodule Batteriemodule enthalten und eine Batterie bilden.

Alternativ kann die elektrische Einrichtung in vorteilhafter Weise als Spannungsmodule Brennstoffzellenmodule enthalten und eine Brennstoffzelleneinrichtung bilden.

Auch ist es vorteilhaft, wenn die elektrische Einrichtung als Spannungsmodule Batteriemodule und Brennstoffzellenmodule enthält und eine Batterie-Brennstoffzelleneinrichtung bildet.

Auch ist es vorteilhaft, wenn die Steuereinrichtung die Vorwiderstände prüft, indem sie den ersten und zweiten Schalter schließt und die schichteigenen Schalter öffnet. Entspricht der gemessene Widerstandswert nicht der Summe der Sollwiderstandswerte der Vorwiderstände, so wird vorzugsweise ein entsprechendes Warnsignal erzeugt.

Auch ist es vorteilhaft, wenn die Steuereinrichtung die Gesamtisolation der elektrischen Einrichtung prüft, indem sie alle Schalter der Schalteinrichtung öffnet und den Widerstand zwischen dem Spannungsanschluss der elektrischen Einrichtung und dem Gehäuse misst. Ist der Widerstand zu klein, so wird ein entsprechendes Fehlersignal erzeugt.

Die Erfindung bezieht sich außerdem auf ein Fahrzeug, insbesondere Schienenfahrzeug. Erfindungsgemäß ist vorgesehen, dass das Fahrzeug eine Anordnung wie oben beschrieben aufweist.

Bezüglich der Vorteile des erfindungsgemäßen Fahrzeugs sowie vorteilhafter Ausgestaltungen des erfindungsgemäßen Fahrzeugs sei auf die obigen Ausführungen im Zusammenhang mit der erfindungsgemäßen Anordnung sowie deren vorteilhafter Ausgestaltungen verwiesen.

Die Erfindung bezieht sich außerdem auf ein Verfahren zum Betreiben einer Anordnung, die ein Gehäuse und zumindest ein in dem Gehäuse befindliches Spannungsmodul aufweist.

Erfindungsgemäß ist vorgesehen, dass das Spannungsmodul eine innere Isolationsschicht und eine äußere Isolationsschicht aufweist, die eine oder mehrere in dem Spannungsmodul enthaltene Zellen von dem Gehäuse elektrisch isolieren, wobei zwischen der inneren und der äußeren Isolationsschicht eine elektrisch leitfähige moduleigene Zwischenschicht angeordnet ist, die Anordnung eine Schalteinrichtung aufweist, die im Prüfbetrieb die moduleigene Zwischenschicht wahlweise mit dem Gehäuse oder einem Spannungsanschluss, insbesondere dem Plus- oder Minuspol des Spannungsmoduls oder einer das Spannungsmodul enthaltenden elektrischen Einrichtung, verbinden kann, mittels der Schalteinrichtung zum Überprüfen der inneren Isolationsschicht die moduleigene Zwischenschicht mit dem Gehäuse verbunden und zum Überprüfen der äußeren Isolationsschicht die moduleigene Zwischenschicht mit dem Spannungsanschluss verbunden wird, während des Überprüfens der inneren oder äu-ßeren Isolationsschicht zumindest ein Messwert erfasst wird und der zumindest eine Messwert ausgewertet und ein Fehlersignal erzeugt wird, wenn die Auswertung des Messwerts auf einen Fehler der Isolation der zu überprüfenden Isolationsschicht hinweist.

Bezüglich der Vorteile des erfindungsgemäßen Verfahrens sowie vorteilhafter Ausgestaltungen des erfindungsgemäßen Verfahrens sei auf die obigen Ausführungen im Zusammenhang mit der erfindungsgemäßen Anordnung sowie deren vorteilhafter Ausgestaltungen verwiesen.

Die Erfindung wird nachfolgend anhand von Ausführungsbeispielen näher erläutert; dabei zeigen beispielhaft

Figur 1 ein Ausführungsbeispiel für eine erfindungsgemäße Anordnung mit einer Messeinrichtung ohne eigener Spannungsquelle,

Figur 2 die Anordnung gemäß Figur 1 während der Prüfung einer äußeren Isolationsschicht eines der Batteriemodule der Anordnung,

Figur 3 die Anordnung gemäß Figur 1 während der Prüfung einer inneren Isolationsschicht eines der Batteriemodule,

Figur 4 ein Ausführungsbeispiel für eine erfindungsgemäße Anordnung mit einer Messeinrichtung mit eigener Wechselspannungsquelle, und

Figur 5 ein Ausführungsbeispiel für eine erfindungsgemäße Anordnung mit einer Messeinrichtung, die im Bereich eines Gleichspannungszwischenkreises integriert ist.

In den Figuren werden für identische oder vergleichbare Komponenten stets dieselben Bezugszeichen verwendet.

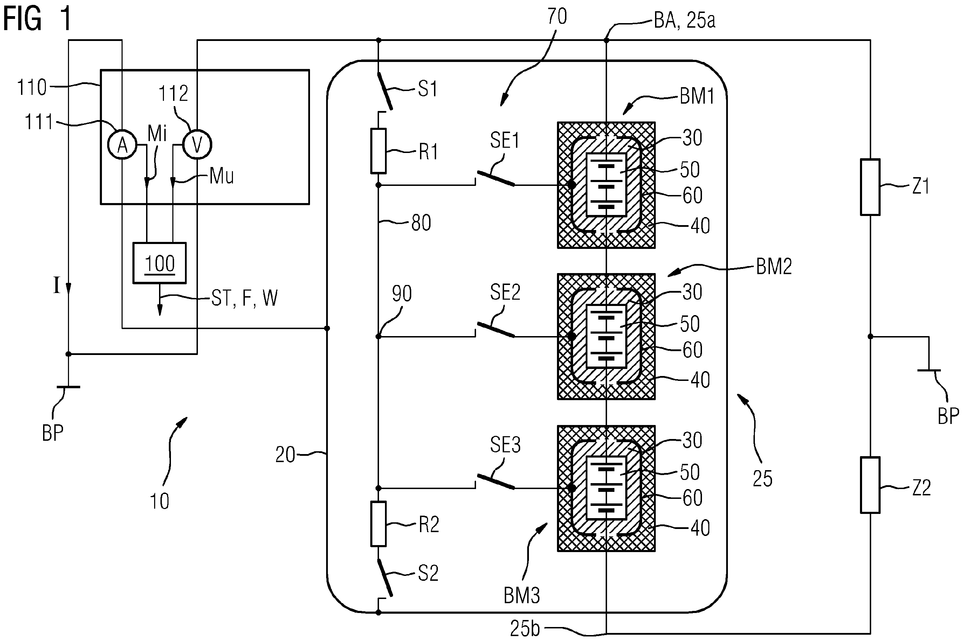

Die Figur 1 zeigt eine Anordnung 10, bei der in einem Gehäuse 20 einer elektrischen Einrichtung 25 in Form einer Batterie zumindest ein Spannungsmodul untergebracht ist. Bei dem Ausführungsbeispiel gemäß Figur 1 wird beispielhaft davon ausgegangen, dass drei Spannungsmodule in Form von Batteriemodulen, die jeweils ein oder mehr Batteriezellen aufweisen, elektrisch in Reihe geschaltet sind. Die Batteriemodule sind mit den Bezugszeichen BM1, BM2 und BM3 gekennzeichnet. Die Anzahl und die Verschaltung der Batteriemodule ist nur beispielhaft zu verstehen: Es können mehr oder weniger Batteriemodule vorhanden sein und die Batteriemodule können auch in anderer Art elektrisch verschaltet sein.

Der Pluspol 25a und der Minuspol 25b der Batterie 25 sind beispielsweise über Impedanzen Z1 und Z2 mit einem Bezugspotential BP verbunden.

Jedes der Batteriemodule BM1, BM2 und BM3 weist jeweils eine innere moduleigene Isolationsschicht 30 und eine moduleigene äußere Isolationsschicht 40 auf, die gemeinsam eine oder mehrere in dem jeweiligen Batteriemodul enthaltene Batteriezellen 50 von dem Gehäuse 20 der Batterie 25 elektrisch isolieren. Die äußeren Isolationsschichten 40 können moduleigene Isolationsschichten 40 sein, wie in der Figur 1 gezeigt; alternativ kann ein modulübergreifendes, gemeinsame Isolationsmaterial vorhanden sein, das abschnittsweise für jedes der Batteriemodule BM1, BM2 und BM3 elektrisch jeweils eine zugeordnete äußere Isolationsschicht 40 bildet.

Zwischen der inneren moduleigenen Isolationsschicht 30 und der äußeren Isolationsschicht 40 ist jeweils eine elektrisch leitfähige moduleigene Zwischenschicht 60 angeordnet.

Die Anordnung 10 weist außerdem eine Schalteinrichtung 70 auf. Die Schalteinrichtung 70 umfasst einen ersten Schalter S1 und einen zweiten Schalter S2, die eine Reihenschaltung 80 bilden. Die Reihenschaltung 80 ist elektrisch zwischen das Gehäuse 20 und einen Spannungsanschluss BA geschaltet. Bei dem Ausführungsbeispiel gemäß Figur 1 ist die Reihenschaltung 80 zwischen das Gehäuse 20 und den Pluspol 25a der Batterie 25 geschaltet; alternativ kann sie auch zwischen das Gehäuse 20 und den Minuspol 25b der Batterie 25 oder zwischen das Gehäuse 20 und einen der Batterieanschlüsse eines der Batteriemodule BM1, BM2 und BM3 geschaltet sein.

Zwischen dem ersten Schalter S1 und dem zweiten Schalter S2 befindet sich elektrisch ein Mittenanschluss 90.

Die Reihenschaltung 80 weist darüber hinaus einen ersten Vorwiderstand R1 und einen zweiten Vorwiderstand R2 auf. Zwischen den Mittenanschluss 90 und den Spannungsanschluss BA ist der erste Vorwiderstand R1 und zwischen den Mittenanschluss 90 und das Gehäuse 20 ist der zweite Vorwiderstand R2 geschaltet. Der erste und zweite Vorwiderstand R1 und R2 weisen vorzugsweise Widerstandswerte zwischen 1 kΩ und 100 kΩ auf.

Die Schalteinrichtung 70 umfasst darüber hinaus für jede der moduleigenen Zwischenschichten 60 jeweils einen schichteigenen Schalter, der an den Mittenanschluss 90 und die jeweilige moduleigene Zwischenschicht 60 angeschlossen ist. Die schichteigenen Schalter sind mit den Bezugszeichen SE1 bis SE3 gekennzeichnet.

Die Anordnung 10 umfasst außerdem eine Steuereinrichtung 100, die die Schalter S1, S2 und SE1 bis SE3 über aus Gründen der Übersicht in der Figur 1 nicht gezeigte Steuerleitungen mittels Steuersignalen ST ansteuern, also ein- und ausschalten, kann, und eine Messeinrichtung 110, die beispielsweise den zwischen dem Spannungsanschluss BA und dem Gehäuse 20 fließenden Strom I mittels einer Messeinheit 111 unter Bildung von Messwerten Mi und die zwischen dem Spannungsanschluss BA und dem Gehäuse 20 anliegende Spannung mittels einer weiteren Messeinheit 112 unter Bildung von Messwerten Mu messen kann. Die Messwerte Mi und Mu werden von der Messseinrichtung 110 zu der Steuereinrichtung 100 übertragen.

Die Steuereinrichtung 100 wird die Messwerte Mi und Mu der Messeinrichtung 110 auf das Einhalten eines vorgegebenen Grenzwertes hin überwachen und ein Fehlersignal F erzeugen, wenn die Messwerte Mi und Mu oder ein daraus abgeleiteter Wert den vorgegebenen Grenzwert nicht einhalten. Beispielsweise kann die Steuereinrichtung 100 mit den Messwerte Mi und Mu einen Widerstandswert errechnen und diesen mit einem vorgegebenen Mindestwiderstandswert vergleichen: Wird der Mindestwiderstandswert unterschritten, so wird das Fehlersignal F erzeugt.

Die Steuereinrichtung 100 ist vorzugsweise derart ausgebildet, dass sie für jedes der Batteriemodule BM1 bis BM3 jeweils individuell den Widerstand der inneren moduleigenen Isolationsschicht 30 und den Widerstand der äußeren Isolationsschicht 40 bestimmen kann:

Zum Überprüfen der äußeren Isolationsschicht 40 eines der Batteriemodule wird sie den ersten Schalter S1 der Schalteinrichtung 70 und den schichteigenen Schalter SE1, SE2 bzw. SE3 des jeweiligen Batteriemoduls BM1, BM2 bzw. BM3 schließen. Der zweite Schalter S2 und die schichteigenen Schalter der übrigen Batteriemodule werden geöffnet oder bleiben geöffnet. Die Steuereinrichtung 100 wird dann die Messwerte Mi und Mu der Messeinrichtung 110 für die ausgewählte Isolationsschicht 40 jeweils auswerten und ggf. ein Fehlersignal F erzeugen, wie dies oben beschrieben wurde.

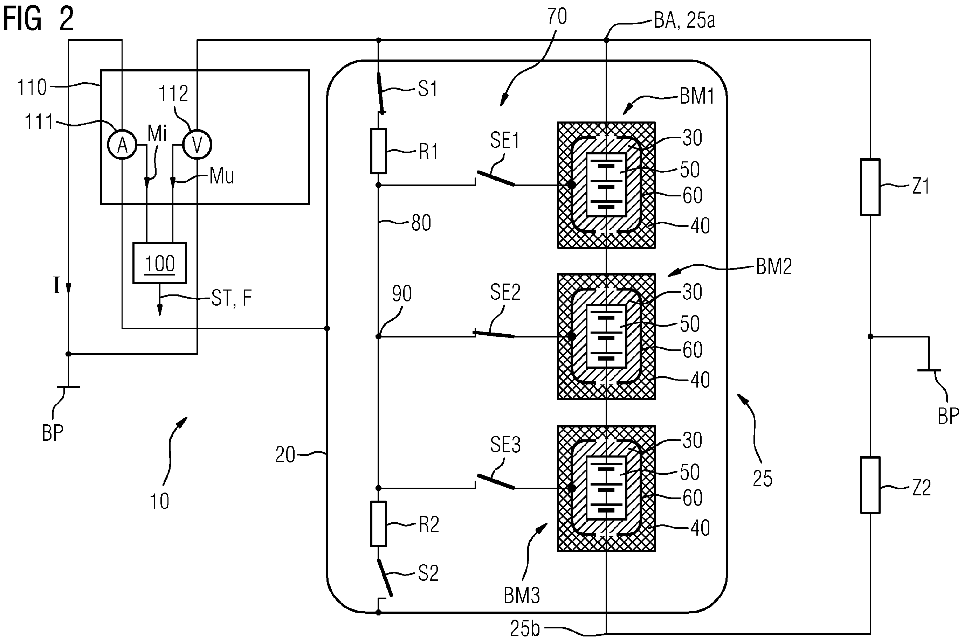

Die Figur 2 zeigt den Schaltzustand der Schalteinrichtung 70 beispielhaft für den Fall der Charakterisierung der äußeren Isolationsschicht 40 des Batteriemoduls BM2: Der erste Schalter S1 der Schalteinrichtung 70 und der schichteigene Schalter SE2 des Batteriemoduls BM2 sind geschlossen; der zweite Schalter S2 und die schichteigenen Schalter SE1 und SE3 der übrigen Batteriemodule BM1 und BM3 sind geöffnet.

Die Messeinrichtung 110 wird bei der in der Figur 2 gezeigten Schalterstellung der Schalteinrichtung 70 den Strom I durch die äußere moduleigene Isolationsschicht 40 des Batteriemoduls BM2 und die Spannung messen, die an der aus der äußeren moduleigenen Isolationsschicht 40 des Batteriemoduls BM2 und dem ersten Vorwierstand R1 gebildeten Reihenschaltung anliegt, und die Messwerte Mi und Mu zu der Steuereinrichtung 100 übertragen.

Die Steuereinrichtung 100 kann mit den Messwerten einen Widerstandswert R für den Widerstand der äußeren moduleigenen Isolationsschicht 40 des Batteriemoduls BM2 unter Berücksichtigung des der Steuereinrichtung bekannten Widerstandswertes des ersten Vorwiderstands R1 errechnen und den errechneten Widerstandswert mit einem Grenzwert Rg, der für jede der inneren und äußeren Isolationsschichten individuell oder für alle Isolationsschichten gleich vorgegeben sein kann, vergleichen. Unterschreitet der Widerstandswert R den Grenzwert Rg, so wird ein Fehlersignal F erzeugt:

$$R < Rg \implies \text{Fehlersignal F}$$

Zum Überprüfen der inneren Isolationsschicht 30 eines der Batteriemodule wird sie den zweiten Schalter S2 der Schalteinrichtung 70 und den schichteigenen Schalter SE1, SE2 bzw. SE3 des jeweiligen Batteriemoduls BM1, BM2 bzw. BM3 schließen und den ersten Schalter S1 öffnen oder geöffnet lassen. Die schichteigenen Schalter der übrigen Batteriemodule werden ebenfalls geöffnet oder bleiben geöffnet. Die Steuereinrichtung 100 wird dann die Messwerte Mi und Mu der Messeinrichtung 110 für die ausgewählte Isolationsschicht 30 jeweils auswerten und ggf. ein Fehlersignal F erzeugen, wie dies oben beschrieben wurde.

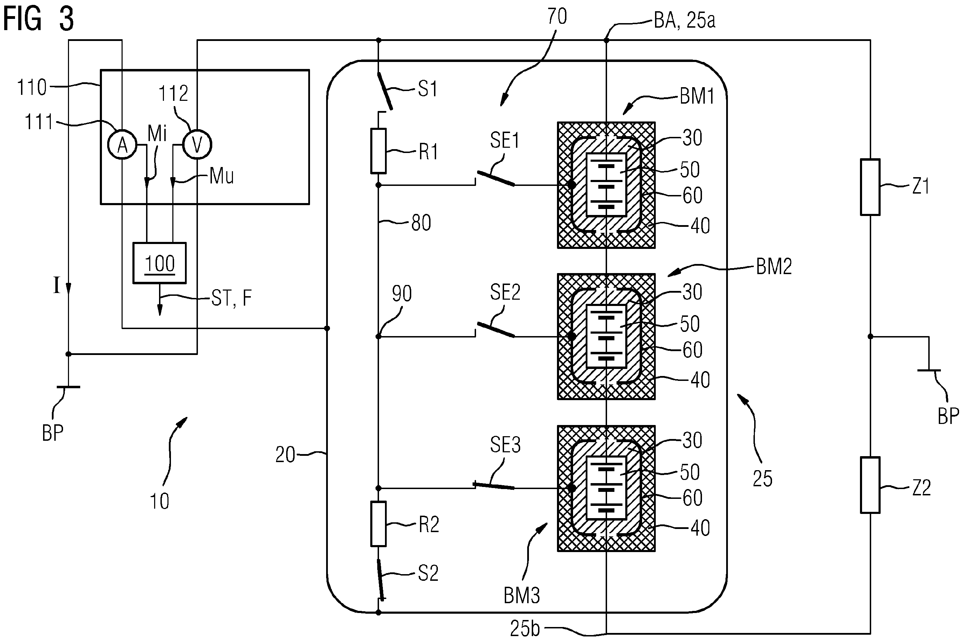

Die Figur 3 zeigt den Schaltzustand der Schalteinrichtung 70 beispielhaft für den Fall der Charakterisierung der inneren Isolationsschicht 30 des Batteriemoduls BM3: Der zweite Schalter S2 der Schalteinrichtung 70 und der schichteigene Schalter SE3 des Batteriemoduls BM3 sind geschlossen; die übrigen Schalter S1, SE1 und SE2 sind geöffnet.

Die Messeinrichtung 110 wird bei der in der Figur 3 gezeigten Schalterstellung der Schalteinrichtung 70 den Strom I durch die innere Isolationsschicht 30 des Batteriemoduls BM3 und die Spannung, die an der Reihenschaltung bestehend aus der inneren Isolationsschicht 30 des Batteriemoduls BM3 und dem zweiten Vorwiderstand R2 abfällt, messen und die Messwerte Mi und Mu zu der Steuereinrichtung 100 übertragen. Die Steuereinrichtung 100 kann mit den Messwerten einen Widerstandswert R für den Widerstand der inneren Isolationsschicht 30 des Batteriemoduls BM3 unter Berücksichtigung des Widerstandswertes des zweiten Vorwiderstands R2 errechnen und diesen mit dem vorgegebenen Grenzwert Rg vergleichen. Unterschreitet der Widerstandswert R den Grenzwert Rg, so wird das Fehlersignal F erzeugt.

In der im Zusammenhang mit den Figuren 2 und 3 beschriebenen Weise kann die Steuereinrichtung also die inneren und äußeren Isolationsschichten 30 und 40 aller Batteriemodule BM1 bis BM3 der Batterie 25 jeweils individuell charakterisieren bzw. individuell auf eine ausreichende Isolationsfähigkeit prüfen.

Bei dem Ausführungsbeispiel gemäß den Figuren 1 bis 3 kann die Potentialsymmetrierung des Pluspols 25a und des Minuspols 25b der Batterie 25 bezüglich des Bezugspotentials BP auch entfallen; die Impedanzen Z1 und Z2 können also weggelassen werden, beispielsweise um zu vermeiden, dass Ströme, die in den Figuren 1 bis 3 je nach der Größe der Impedanzen über diese fließen können, einen Einfluss auf die Messung der Isolationsfähigkeit der Isolationsschichten ausüben.

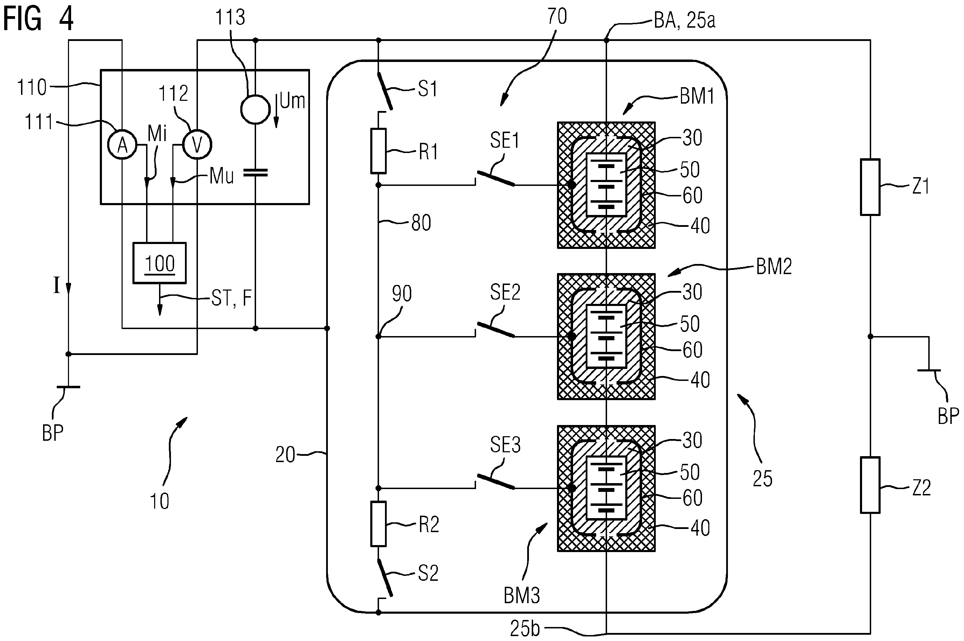

Die Figur 4 zeigt eine Variante des Ausführungsbeispiels gemäß Figur 1. Bei dem Ausführungsbeispiel gemäß Figur 4 ist die Messeinrichtung 110 eine aktive Messeinrichtung, die zum Überprüfen der inneren und äußeren Isolationsschichten 30 und 40 mittels einer internen Wechselspannungsquelle 113 eine Wechselspannung Um, insbesondere im zeitlichen Verlauf rechteckförmige Wechselspannung, an die jeweils mittels der Schalteinrichtung 70 zur Prüfung ausgewählte Isolationsschicht anlegt.

Mittels der Messeinheiten 111 und 112 wird ein Strommesswert Mi, der den Wechselstrom I durch die Isolationsschicht angibt, und ein Spannungsmesswert Mu, der die Wechselspannung Um angibt, gemessen und zu der Steuereinrichtung 100 übermittelt. Die Steuereinrichtung 100 kann die Messwerte Mi und Mu unter Bildung von Widerstandswerten R auswerten und mit dem Grenzwert Rg vergleichen, wie dies oben im Zusammenhang mit den Figuren 1 bis 3 erläutert wurde.

Bei den Ausführungsbeispielen gemäß den Figuren 1 und 4 kann die Steuereinrichtung 100 darüber hinaus die Gesamtisolation der Batterie 25 prüfen, indem sie alle Schalter S1, S2 und SE1 bis SE3 öffnet und den Widerstand zwischen dem Spannungsanschluss BA und dem Gehäuse 20 misst. Ist der Widerstand zu klein, so wird ein entsprechendes Warnsignal W erzeugt.

Bei den Ausführungsbeispielen gemäß den Figuren 1 und 4 kann die Steuereinrichtung 100 außerdem die Vorwiderstände R1 und R2 prüfen, indem sie die Schalter S1 und S2 schließt und die Schalter SE1 bis SE3 öffnet. Entspricht der gemessene Widerstandswert nicht der Summe der Sollwiderstandswerte der Vorwiderstände R1 und R2, so wird ein entsprechendes Warnsignal W erzeugt.

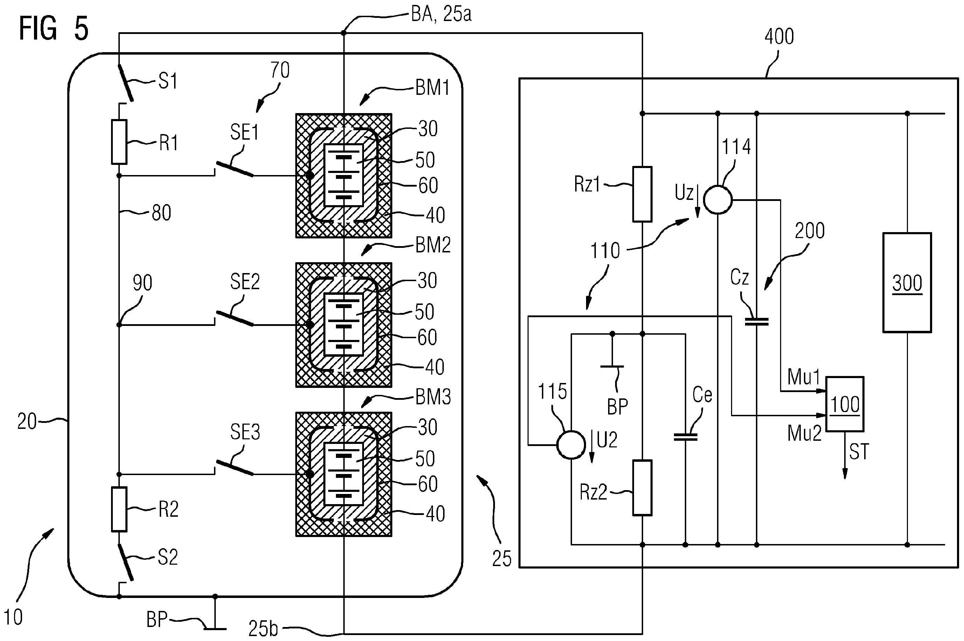

Die Figur 5 zeigt ein Ausführungsbeispiel für eine Anordnung 10, bei der an eine elektrische Einrichtung 25 ein Gleichspannungszwischenkreis 200 und zumindest eine Umrichtereinheit 300 angeschlossen sind. Zwischen den Pluspol 25a und den Minuspol 25b der elektrischen Einrichtung 25 ist ein Zwischenkreiskondensator Cz geschaltet, zu dem eine Reihenschaltung aus zwei Zwischenkreiswiderständen Rz1 und Rz2 parallel liegt. Zwischen das Bezugspotential BP und den Minuspol 25b ist ein Glättungskondensator Ce geschaltet, der parallel zu dem Zwischenkreiswiderstand Rz2 liegt.

Eine Messeinheit 114 einer Messeinrichtung 110 misst die Spannung Uz am Gleichspannungszwischenkreis 200 unter Bildung eines Messwerts Mu1 und eine Messeinheit 115 der Messeinrichtung 110 misst die Spannung U2, die an dem Zwischenkreiswiderstand Rz2 und damit an dem Glättungskondensator Ce anliegt, unter Bildung eines Messwerts Mu2.

Die Steuereinrichtung 100 wertet die Messwerte Mu1 und Mu2 aus und erzeugt ein Fehlersignal ST, wenn gilt

$$VW = |U2/Uz - Rz2/(Rz1+Rz2)| > SW$$

wobei VW einen Vergleichswert und SW einen vorgegebenen Schwellenwert bezeichnet.

Solange der Vergleichswert VW Null beträgt oder zumindest näherungsweise Null beträgt, ist die Isolation der elektrischen Einrichtung 25 fehlerfrei und es liegt auch kein Erdschluss vor.

Im Rahmen der Isolationsmessungen kann die Steuereinrichtung 100 die Schalteinrichtung 70 umschalten, um für die Isolationsmessung einzelne Isolationsschichten der elektrischen Einrichtung 25 gezielt auszuwählen, wie dies oben im Zusammenhang mit den Figuren 1 bis 4 beispielhaft erläutert wurde; diesbezüglich gelten die obigen Erläuterungen entsprechend.

Der oder die Umrichtereinheiten 300, der Zwischenkreiskondensator Cz, die Zwischenkreiswiderstände Rz1 und Rz2, der Glättungskondensator Ce, die Messeinheit 114, die Messeinheit 115 und die Steuereinrichtung 100 können beispielsweise - wie in der Figur 5 gezeigt - in einem Traktionsumrichter 400 eines Fahrzeugs, insbesondere Schienenfahrzeugs integriert sein.

Bei den Ausführungsbeispielen gemäß den Figuren 1 bis 5 sind in der elektrischen Einrichtung 25 nur Batteriemodule vorhanden. Alternativ oder zusätzlich zu den in den Figuren 1 bis 5 gezeigten Batteriemodulen können auch Brennstoffzellenmodule, die jeweils eine oder mehrere Brennstoffzellen aufweisen und jeweils mittels einer inneren und einer äußeren Isolationsschicht isoliert sind, innerhalb des Gehäuses 20 angeordnet werden; in diesem Falle würde die elektrischen Einrichtung 25 eine Brennstoffzelleneinrichtung oder eine Batterie-Brennstoffzelleneinrichtung bilden; die obigen beispielhaften Erläuterungen im Zusammenhang mit der individuellen messtechnischen Charakterisierung der Isolationsschichten gelten in diesem Falle entsprechend.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Bezugszeichenliste

| | |
|---|---|
| 10 | Anordnung |
| 20 | Gehäuse |
| 25 | elektrische Einrichtung / Batterie |
| 25a | Pluspol |
| 25b | Minuspol |
| 30 | innere Isolationsschicht |
| 40 | äußere Isolationsschicht |
| 50 | Batteriezelle |
| 60 | Zwischenschicht |
| 70 | Schalteinrichtung |
| 80 | Reihenschaltung |
| 90 | Mittenanschluss |
| 100 | Steuereinrichtung |
| 110 | Messeinrichtung |
| 111 | Messeinheit |
| 112 | Messeinheit |
| 113 | interne Wechselspannungsquelle |
| 114 | Messeinheit |
| 115 | Messeinheit |
| 200 | Gleichspannungszwischenkreis |
| 300 | Umrichtereinheit |
| 400 | Traktionsumrichter |

| | |
|---|---|
| BA | Spannungsanschluss |
| BM1 | Batteriemodul / Spannungsmodul |
| BM2 | Batteriemodul / Spannungsmodul |
| BM3 | Batteriemodul / Spannungsmodul |
| BP | Bezugspotential |
| Ce | Glättungskondensator |
| Cz | Zwischenkreiskondensator |
| F | Fehlersignal |
| I | Strom |
| Mi | Messwert |
| Mu | Messwert |
| Mu1 | Messwert |
| Mu2 | Messwert |
| R1 | erster Vorwiderstand |
| R2 | zweiter Vorwiderstand |
| Rz1 | Zwischenkreiswiderstand |
| Rz2 | Zwischenkreiswiderstand |
| S1 | erster Schalter |

S2 zweiter Schalter
SE1 schichteigener Schalter
SE2 schichteigener Schalter
SE3 schichteigener Schalter
ST Fehlersignal
Um Wechselspannung
Uz Spannung
W Warnsignal
Z1 Impedanz
Z2 Impedanz

**Patentansprüche**

1. Anordnung (10) mit einem Gehäuse (20) und zumindest einem in dem Gehäuse (20) befindlichen Spannungsmodul (BM1-BM3), wobei

   - das Spannungsmodul (BM1-BM3) eine innere Isolationsschicht (30) und eine äußere Isolationsschicht (40) aufweist, die eine oder mehrere in dem Spannungsmodul (BM1-BM3) enthaltene Zellen von dem Gehäuse (20) elektrisch isolieren, wobei zwischen der inneren und der äußeren Isolationsschicht (30, 40) eine elektrisch leitfähige moduleigene Zwischenschicht (60) angeordnet ist,
   - die Anordnung (10) eine Schalteinrichtung (70) aufweist, die im Prüfbetrieb die moduleigene Zwischenschicht (60) wahlweise mit dem Gehäuse (20) oder einem Spannungsanschluss (BA), insbesondere dem Plus- oder Minuspol des Spannungsmoduls (BM1-BM3) oder einer das Spannungsmodul (BM1-BM3) enthaltenden elektrischen Einrichtung (25), verbinden kann,
   - die Anordnung (10) eine Steuereinrichtung (100) aufweist, die mittels der Schalteinrichtung (70) zum Überprüfen der inneren Isolationsschicht (30) die moduleigene Zwischenschicht (60) mit dem Gehäuse (20) und zum Überprüfen der äußeren Isolationsschicht (40) die moduleigene Zwischenschicht (60) mit dem Spannungsanschluss (BA) verbindet,
   - eine Messeinrichtung (110) vorhanden ist, die während des Überprüfens der inneren oder äußeren Isolationsschicht (30, 40) zumindest einen Messwert (Mi, Mu, Mu1, Mu2) erfasst und
   - die Steuereinrichtung (100) den zumindest einen Messwert (Mi, Mu, Mu1, Mu2) auswertet und ein Fehlersignal (F) erzeugt, wenn die Auswertung auf einen Fehler der Isolation der zu überprüfenden Isolationsschicht (30) hinweist.

2. Anordnung (10) nach Anspruch 1,
   **dadurch gekennzeichnet, dass**
   die Steuereinrichtung (100) den zumindest einen Messwert (Mi, Mu, Mu1, Mu2) der Messeinrichtung (110) oder zumindest einen daraus abgeleiteten Wert auf das Einhalten zumindest eines vorgegebenen Grenzwertes hin überwacht und ein Fehlersignal (F) erzeugt, wenn der zumindest eine Messwert (Mi, Mu, Mu1, Mu2) oder der zumindest eine abgeleitete Wert den zumindest einen vorgegebenen Grenzwert nicht einhält.

3. Anordnung (10) nach einem der voranstehenden Ansprüche, **dadurch gekennzeichnet, dass**

   - in dem Gehäuse (20) zwei oder mehr Spannungsmodule (BM1-BM3) enthalten sind, die jeweils durch eine innere Isolationsschicht (30) und eine äußere Isolationsschicht (40) von dem Gehäuse (20) elektrisch isoliert sind, wobei zwischen der inneren und der äußeren Isolationsschicht (30, 40) jeweils eine elektrisch leitfähige moduleigene Zwischenschicht (60) angeordnet ist,
   - die Schalteinrichtung die moduleigenen Zwischenschichten (60) der Spannungsmodule (BM1-BM3) jeweils wahlweise mit dem Gehäuse (20) oder dem Spannungsanschluss (BA) verbinden kann, und
   - die Steuereinrichtung (100) die Isolationsschicht (30) jedes der Spannungsmodule (BM1-BM3) individuell überprüfen kann und zum Überprüfen der inneren Isolationsschicht (30) eines zur Prüfung ausgewählten Spannungsmoduls (BM1-BM3) mittels der Schalteinrichtung (70) die moduleigene Zwischenschicht (60) des jeweiligen Spannungsmoduls (BM1-BM3) mit dem Gehäuse (20) und zum Überprüfen der äußeren Isolationsschicht (40) des jeweiligen Spannungsmoduls (BM1-BM3) mittels der Schalteinrichtung jeweils die moduleigene Zwischenschicht (60) des jeweiligen Spannungsmoduls (BM1-BM3) mit dem Spannungsanschluss (BA) verbindet.

4. Anordnung (10) nach einem der voranstehenden Ansprüche, **dadurch gekennzeichnet, dass**

- in dem Gehäuse (20) zwei oder mehr Spannungsmodule (BM1-BM3) enthalten sind, die Bestandteile einer elektrischen Einrichtung (25) bilden, und
- das Gehäuse (20) auf einem Bezugspotential (BP) liegt und die Potentiale eines Pluspols (25a) und eines Minuspols (25b) der elektrischen Einrichtung (25) bezüglich des Bezugspotentials (BP) mittels einer äußeren Beschaltung (Z1, Z2, Rz1, Rz2) festgelegt sind.

5. Anordnung (10) nach Anspruch 4,
**dadurch gekennzeichnet, dass**

- die Messeinrichtung (110) einen Spannungsmesswert, der die Spannung zwischen dem Gehäuse (20) und einem Plus- oder Minuspol (25a, 25b) der elektrischen Einrichtung (25) angibt, misst und
- die Steuereinrichtung (100) ein Warnsignal (W) erzeugt, wenn der Spannungsmesswert betragsmäßig eine vorgegebene untere Grenze, insbesondere einen Betrag von 20 % der zwischen dem Plus- und Minuspol (25a, 25b) der elektrischen Einrichtung (25) anliegenden Gesamtspannung, unterschreitet oder eine vorgegebene obere Grenze, insbesondere einen Betrag von 80 % der zwischen dem Plus- und Minuspol (25a, 25b) der elektrischen Einrichtung (25) anliegenden Gesamtspannung, überschreitet.

6. Anordnung (10) nach einem der voranstehenden Ansprüche,
**dadurch gekennzeichnet, dass**
die Messeinrichtung (110) eine aktive Messeinrichtung (110) ist, die zum Überprüfen der inneren oder äußeren Isolationsschicht (30, 40) eine Wechselspannung (Um), insbesondere im zeitlichen Verlauf rechteckförmige Wechselspannung, an die jeweilige mittels der Schalteinrichtung (70) zur Prüfung ausgewählte Isolationsschicht (30, 40) anlegt und als Messwert (Mi, Mu, Mu1, Mu2) einen Strommesswert, der den Strom durch die Isolationsschicht (30, 40) angibt, oder einen Widerstandsmesswert, der den Widerstand der Isolationsschicht (30, 40) angibt, erzeugt.

7. Anordnung (10) nach einem der voranstehenden Ansprüche, **dadurch gekennzeichnet, dass**
die Messeinrichtung (110) durch einen Isolationswächter gebildet ist oder einen solchen auch umfasst.

8. Anordnung (10) nach einem der voranstehenden Ansprüche, **dadurch gekennzeichnet, dass**

- die Schalteinrichtung (70) eine einen ersten Schalter (S1) und einen zweiten Schalter (S2) aufweisende Reihenschaltung (80) umfasst, die elektrisch zwischen das Gehäuse (20) oder den Spannungsanschluss (BA) geschaltet ist und einen Mittenanschluss (90) aufweist und
- jede der moduleigenen Zwischenschichten (60) jeweils mittels eines schichteigenen Schalters an den Mittenanschluss (90) angeschlossen ist.

9. Anordnung (10) nach Anspruch 8,
**dadurch gekennzeichnet, dass**

- die Reihenschaltung (80) einen ersten Vorwiderstand (R1) und einen zweiten Vorwiderstand (R2) aufweist und
- zwischen den Mittenanschluss (90) und den Spannungsanschluss (BA) der erste Vorwiderstand (R1) und zwischen den Mittenanschluss (90) und das Gehäuse (20) der zweite Vorwiderstand (R2) geschaltet ist.

10. Anordnung (10) nach einem der voranstehenden Ansprüche, **dadurch gekennzeichnet, dass**
der erste und zweite Vorwiderstand (R1, R2) Widerstandswerte zwischen 1 k$\Omega$ und 100 k$\Omega$ aufweisen.

11. Anordnung (10) nach einem der voranstehenden Ansprüche, **dadurch gekennzeichnet, dass**
die Steuereinrichtung (100) dazu ausgebildet ist,

- zum Überprüfen der inneren Isolationsschicht (30) eines der Spannungsmodule (BM1-BM3) den ersten Schalter (S1) und den schichteigenen Schalter des jeweiligen Spannungsmoduls (BM1-BM3) zu schließen und den zweiten Schalter (S2) zu öffnen oder geöffnet zu lassen und
- zum Überprüfen der äußeren Isolationsschicht (40) eines der Spannungsmodule (BM1-BM3) den zweiten Schalter (S2) und den schichteigenen Schalter des jeweiligen Spannungsmoduls (BM1-BM3) zu schließen und den ersten Schalter (S1) zu öffnen oder geöffnet zu lassen.

12. Anordnung (10) nach einem der voranstehenden Ansprüche, **dadurch gekennzeichnet, dass**

- das oder die Spannungsmodule (BM1-BM3) zusätzlich zu der inneren Isolationsschicht (30) und der äußeren Isolationsschicht (40) jeweils weitere Isolationsschichten und weitere leitfähige moduleigene Zwischenschichten (60) aufweist und
- die Schalteinrichtung (70) eine Vielzahl an Schaltern aufweist, die eine individuelle Auswahl jeder einzelnen der Isolationsschichten (30, 40) eines jeden der Spannungsmodule (BM1-BM3) zum Zwecke des Überprüfens der jeweiligen Isolationsschicht (30) mit Hilfe der Messeinrichtung (110) ermöglichen.

13. Anordnung (10) nach einem der voranstehenden Ansprüche, **dadurch gekennzeichnet, dass**

- die elektrische Einrichtung (25) als Spannungsmodule (BM1-BM3) Batteriemodule enthält und eine Batterie bildet,
- die elektrische Einrichtung (25) als Spannungsmodule (BM1-BM3) Brennstoffzellenmodule enthält und eine Brennstoffzelleneinrichtung bildet oder
- die elektrische Einrichtung (25) als Spannungsmodule (BM1-BM3) Batteriemodule und Brennstoffzellenmodule enthält und eine Batterie-Brennstoffzelleneinrichtung bildet.

14. Fahrzeug, insbesondere Schienenfahrzeug, mit einer Anordnung (10), die ein Gehäuse (20) und zumindest ein in dem Gehäuse (20) befindliches Spannungsmodul (BM1-BM3) aufweist, **dadurch gekennzeichnet, dass** die Anordnung (10) eine Anordnung (10) nach einem der voranstehenden Ansprüche ist.

15. Verfahren zum Betreiben einer Anordnung (10), die ein Gehäuse (20) und zumindest ein in dem Gehäuse (20) befindliches Spannungsmodul (BM1-BM3) aufweist, wobei

- das Spannungsmodul (BM1-BM3) eine innere Isolationsschicht (30) und eine äußere Isolationsschicht (40) aufweist, die eine oder mehrere in dem Spannungsmodul (BM1-BM3) enthaltene Zellen (50) von dem Gehäuse (20) elektrisch isolieren, wobei zwischen der inneren und der äußeren Isolationsschicht (30, 40) eine elektrisch leitfähige moduleigene Zwischenschicht (60) angeordnet ist,
- die Anordnung (10) eine Schalteinrichtung (70) aufweist, die im Prüfbetrieb die moduleigene Zwischenschicht (60) wahlweise mit dem Gehäuse (20) oder einem Spannungsanschluss (BA), insbesondere dem Plus- oder Minuspol des Spannungsmoduls (BM1-BM3) oder einer das Spannungsmodul (BM1-BM3) enthaltenden elektrischen Einrichtung (25), verbinden kann,
- mittels der Schalteinrichtung (70) zum Überprüfen der inneren Isolationsschicht (30) die moduleigene Zwischenschicht (60) mit dem Gehäuse (20) verbunden und zum Überprüfen der äußeren Isolationsschicht (40) die moduleigene Zwischenschicht (60) mit dem Spannungsanschluss (BA) verbunden wird,
- während des Überprüfens der inneren oder äußeren Isolationsschicht (30, 40) zumindest ein Messwert (Mi, Mu, Mu1, Mu2) erfasst wird und
- der zumindest eine Messwert (Mi, Mu, Mu1, Mu2) ausgewertet und ein Fehlersignal (F) erzeugt wird, wenn die Auswertung des Messwerts auf einen Fehler der Isolation der zu überprüfenden Isolationsschicht (30) hinweist.

## Claims

1. Arrangement (10) having a housing (20) and at least one voltage module (BM1-BM3) located in the housing (20), wherein

- the voltage module (BM1-BM3) has an inner isolation layer (30) and an outer isolation layer (40), which isolate one or more cells contained in the voltage module (BM1-BM3) electrically from the housing (20), wherein an electrically conductive module-specific intermediate layer (60) is arranged between the inner and the outer isolation layer (30, 40),
- the arrangement (10) has a switching facility (70), which, during test operation, can connect the module-specific intermediate layer (60) optionally with the housing (20) or a voltage terminal (BA), in particular the positive or negative pole of the voltage module (BM1-BM3) or an electrical facility (25) containing the voltage module (BM1-BM3),
- the arrangement (10) has a control facility (100), which uses the switching facility (70) to connect the module-specific intermediate layer (60) with the housing (20) in order to check the inner isolation layer (30) and to connect the module-specific intermediate layer (60) with the voltage terminal (BA) in order to check the outer isolation layer (40),

- a measuring facility (110) is available, which detects at least one measured value (Mi, Mu, Mu1, Mu2) while checking the inner or outer isolation layer (30, 40) and
- the control facility (100) evaluates the at least one measured value (Mi, Mu, Mu1, Mu2) and generates a fault signal (F) when the evaluation indicates an error of the isolation of the isolation layer (30) to be checked.

2. Arrangement (10) according to claim 1,
**characterised in that**
the control facility (100) monitors the at least one measured value (Mi, Mu, Mu1, Mu2) of the measuring facility (110) or at least one value derived therefrom for compliance with at least one predetermined limit value and generates a fault signal (F) if the at least one measured value (Mi, Mu, Mu1, Mu2) or the at least one derived value does not comply with the at least one predetermined limit value.

3. Arrangement (10) according to one of the preceding claims, **characterised in that**

- two or more voltage modules (BM1-BM3) are contained in the housing (20) and are electrically isolated from the housing (20) by an inner isolation layer (30) and an outer isolation layer (40) in each case, wherein an electrically conductive module-specific intermediate layer (60) is arranged between the inner and the outer isolation layer (30, 40) in each case,
- the switching facility can connect the module-specific intermediate layers (60) of the voltage modules (BM1-BM3) in each case optionally with the housing (20) or the voltage terminal (BA), and
- the control facility (100) can individually check the isolation layer (30) of each of the voltage modules (BM1-BM3) and in order to check the inner isolation layer (30) of a voltage module (BM1-BM3) selected for testing purposes uses the switching facility (70) to connect the module-specific intermediate layer (60) of the respective voltage module (BM1-BM3) with the housing (20) and in order to check the outer isolation layer (40) of the respective voltage module (BM1-BM3) uses the switching facility to connect the module-specific intermediate layer (60) of the respective voltage module (BM1-BM3) with the voltage terminal (BA) in each case.

4. Arrangement (10) according to one of the preceding claims, **characterised in that**

- two or more voltage modules (BM1-BM3) which form integral parts of an electrical facility (25) are contained in the housing (20) and
- the housing (20) lies on a reference potential (BP) and the potentials of a positive pole (25a) and a negative pole (25b) of the electrical facility (25) are determined with respect to the reference potential (BP) by means of an outer protective circuit (Z1, Z2, Rz1, Rz2).

5. Arrangement (10) according to claim 4,
**characterised in that**

- the measuring facility (110) measures a voltage measured value, which specifies the voltage between the housing (20) and a positive or negative pole (25a, 26b) of the electrical facility (25), and
- the control facility (100) generates a warning signal (W) when, in terms of amount, the voltage measured value does not reach a predetermined lower limit, in particular a sum of 20% of the overall voltage applied between the positive and negative pole (25a, 25b) of the electrical facility (25) or exceeds a predetermined upper limit, in particular a sum of 80% of the overall voltage applied between the positive and negative pole (25a, 25b) of the electrical facility (25).

6. Arrangement (10) according to one of the preceding claims, **characterised in that**
the measuring facility (110) is an active measuring facility (110) which, for checking the inner or outer isolation layer (30, 40), applies an alternating voltage (Um), in particular over the temporal course a rectangular alternating voltage, to the respective isolation layer (30, 40) selected by means of the switching facility (70) for testing purposes and, as a measured value (MI, Mu, Mu1, Mu2), applies a current measured value, which specifies the current through the isolation layer (30, 40), or a resistance measured value, which specifies the resistance of the isolation layer (30, 40).

7. Arrangement (10) according to one of the preceding claims, **characterised in that**
the measuring facility (110) is formed by an isolation monitor or also comprises one such.

8. Arrangement (10) according to one of the preceding claims, **characterised in that**

- the switching facility (70) comprises a series circuit (80) having a first switch (S1) and a second switch (S2), which is switched electrically between the housing (20) or the voltage terminal (BA) and has a central terminal (90) and
- each of the module-specific intermediate layers (60) is connected to the central terminal (90) by means of a layer-specific switch in each case.

9. Arrangement (10) according to claim 8,
**characterised in that**

- the series circuit (80) has a first series resistor (R1) and a second series resistor (R2) and
- the first series resistor (R1) is switched between the central terminal (90) and the voltage terminal (BA) and the second series resistor (R2) is switched between the central terminal (90) and the housing (20).

10. Arrangement (10) according to one of the preceding claims, **characterised in that**

the first and second series resistor (R1, R2) have resistance values of
between 1 kΩ und 100 kΩ.

11. Arrangement (10) according to one of the preceding claims, **characterised in that**
the control facility (100) is designed,

- in order to check the inner isolation layer (30) of one of the voltage modules (BM1-BM3), to close the first switch (51) and the slice-specific switch of the respective voltage module (BM1-BM3) or to open or leave open the second switch (S2) and
- in order to check the outer isolation layer (40) of one of the voltage modules (BM1-BM3), to close the second switch (S2) and the slice-specific switch of the respective voltage module (BM1-BM3) and to open or leave open the first switch (S1).

12. Arrangement (10) according to one of the preceding claims, **characterised in that**

- in addition to the inner isolation layer (30) and the outer isolation layer (40) the voltage module or modules (BM1-BM3) has/have further isolation layers and further conductive module-specific intermediate layers (60) in each instance and
- the switching facility (70) has a plurality of switches, which enable an individual selection of each individual isolation layer (30, 40) of each of the voltage modules (BM1-BM3) for the purpose of checking the respective isolation layer (30) with the aid of the measuring facility (110) .

13. Arrangement (10) according to one of the preceding claims, **characterised in that**

- the electrical facility (25) contains battery modules as voltage modules (BM1-BM3) and forms a battery,
- the electrical facility (25) contains fuel cell modules as voltage modules (BM1-BM3) and forms a battery or
- the electrical facility (25) contains battery modules and fuel cell modules as voltage modules (BM1-BM3) and forms a battery fuel cell facility.

14. Vehicle, in particular rail vehicle, having an arrangement (10), which has a housing (20) and at least one voltage module (BM1-BM3) located in the housing (20),
**characterised in that**
the arrangement (10) is an arrangement (10) according to one of the preceding claims.

15. Method for operating an arrangement (10), which has a housing (20) and at least one voltage module (BM1-BM3) located in the housing (20), wherein

- the voltage module (BM1-BM3) has an inner isolation layer (30) and an outer isolation layer (40), which electrically isolate one or more cells (50) contained in the voltage module (BM1-BM3) from the housing (20), wherein an electrically conductive module-specific intermediate layer (60) is arranged between the inner and the outer isolation layer (30, 40),
- the arrangement (10) has a switching facility (70), which, during test operation, can connect the module-specific intermediate layer (60) optionally with the housing (20) or a voltage terminal (BA), in particular the positive or negative pole of the voltage module (BM1-BM3) or an electrical facility (25) containing the voltage module (BM1-B3),
- by means of the control facility (70) for checking the inner isolation layer (30), the module-specific intermediate layer (60) is connected with the housing (20) and for checking the outer isolation layer (40) the module-specific intermediate layer (60) is connected with the voltage terminal (BA),
- while checking the inner or outer isolation layer (30, 40) at least one measured value (Mi, Mu, Mu1, Mu2) is detected and
- the at least one measured value (Mi, Mu, Mu1, Mu2) is evaluated and a fault signal (F) is generated when the evaluation of the measured value indicates a fault in the isolation of the isolation layer (30) to be checked.

**Revendications**

1.  Montage (10) comprenant un boîtier (20) et au moins un module (BM1-BM3) de tension se trouvant dans le boîtier (20),
    dans lequel

    - le module (BM1-BM3) de tension a une couche (30) intérieure isolante et une couche (40) extérieure isolante, qui isolent électriquement du boîtier (20) une ou plusieurs cellules contenues dans le module (BM1-BM3) de tension, une couche (60) intermédiaire propre au module et conductrice de l'électricité, étant disposée entre la couche (30) intérieure isolante et la couche (40) extérieure isolante,
    - le montage (10) a un dispositif (70) de coupure qui, en fonctionnement de contrôle, peut relier la couche (60) intermédiaire propre au module ou soit au boîtier (20) ou à une borne (BA) de tension, notamment au pôle plus ou au pôle moins du module (BM1-BM3) de tension ou à un dispositif (25) électrique contenant le module (BM1-BM3) de tension,
    - le montage (10) a un dispositif (100) qui, au moyen du dispositif (70) de coupure relie, pour le contrôle de la couche (30) intérieure isolante, la couche (60) intermédiaire propre au module au boîtier (20) et, pour le contrôle de la couche (40) extérieure isolante, la couche (60) intermédiaire propre au module à la borne (BA) de tension,
    - il y a un dispositif (110) de mesure qui, pendant le contrôle de la couche (30) intérieure isolante ou de la couche (40) extérieure isolante, détecte au moins une valeur (Mi, Mu, Mu1, Mu2) de mesure et
    - le dispositif (100) de commande exploite la au moins une valeur (Mi, Mu, Mu1, Mu2) de mesure et produit un signal (F) de défaut, si l'exploitation indique un défaut de l'isolation de la couche (30) isolante à contrôler.

2.  Montage (10) suivant la revendication 1,
    **caractérisé en ce que**
    le dispositif (100) de commande contrôle que la au moins une valeur (Mi, Mu, Mu1, Mu2) de mesure du dispositif (110) de mesure ou au moins une valeur, qui s'en déduit, respecte au moins une valeur limite donnée à l'avance et produit un signal (F) de défaut, si la au moins une valeur (Mi, Mu, Mu1, Mu2) de mesure ou la au moins une valeur, qui s'en déduit, ne respecte pas la au moins une valeur limite donnée à l'avance.

3.  Montage (10) suivant l'une des revendications précédentes, **caractérisé en ce que**

    - dans le boîtier (20) sont contenus deux ou plusieurs modules (BM1-BM3) de tension, qui sont isolées électriquement du boîtier (20) chacun par une couche (30) intérieure isolante et par une couche (40) extérieure isolante, une couche (60) intermédiaire propre au module et conductrice de l'électricité, étant disposée entre la couche (30) intérieure isolante et la couche (40) extérieure isolante,
    - le dispositif de coupure peut relier les couches (60) intermédiaires propres au module des modules (BM1-BM3) de tension respectivement au choix au boîtier (20) ou à la borne (BA) de tension et, et
    - le dispositif (100) de commande peut contrôler individuellement la couche (30) isolante de chacun des modules (BM1-BM3) de tension et, pour le contrôle de la couche (30) intérieure isolante d'un module (BM1-BM3) de tension sélectionné pour le contrôle, relie, au moyen du dispositif (70) de coupure, la couche (60) intermédiaire propre au module du module (BM1-BM3) de tension respectif au boîtier (20) et, pour le contrôle de la couche (40) extérieure isolante du module (BM1-BM3) de tension respectif, au moyen du dispositif de coupure, respectivement ma couche (60) intermédiaire propre au module du module (BM1-BM3) de tension respectif à la borne (BA) de tension.

4.  Montage (10) suivant l'une des revendications précédentes, **caractérisé en ce que**

- dans le boîtier (20) sont contenus deux ou plusieurs modules (BM1-BM3) de tension, qui sont des parties constitutives d'un dispositif (25) électrique, et

- le boîtier (20) est à un potentiel (BP) de référence et les potentiels d'un pôle (25a) plus et d'un pôle (25b) moins du dispositif (25) électrique sont fixés par rapport au potentiel (BP) de référence au moyen d'un circuit (Z1, Z2, Rz1, Rz2) extérieur.

5. Montage (10) suivant la revendication 4,
   **caractérisé en ce que**

   - le dispositif (110) de mesure mesure une valeur de mesure de la tension, qui indique la tension entre le boîtier (20) et un pôle (25a, 25b) plus ou moins du dispositif (25) électrique, et
   - le dispositif (100) de commande produit un signal (W) d'alerte, si la valeur de mesure de la tension passe en-dessous une valeur absolue d'une limite inférieure donnée à l'avance, notamment d'un montant représentant 20% de la tension totale s'appliquant entre le pôle (25a) plus et le pôle (25b) moins du dispositif (25) électrique, ou si une limite supérieure donnée à l'avance, notamment représentant un montant de 80% de la tension d'ensemble s'appliquant entre le pôle (25a) plus et le pôle (25b) moins du dispositif (25) électrique est dépassée.

6. Montage (10) suivant l'une des revendications précédentes, **caractérisé en ce que**
   le dispositif (110) de mesure est un dispositif (110) de mesure actif qui, pour le contrôle de la couche (30) intérieure isolante ou de la couche (40) extérieure isolante applique une tension (Um) alternative, notamment une tension alternative en forme de rectangle dans la courbe en fonction du temps, à la couche (30, 40) isolante sélectionnée pour le contrôle respectivement au moyen du dispositif (70) de coupure et produit, comme valeur (Mi, Mu, Mu1, Mu2) de mesure, une valeur de mesure de courant, qui indique le courant traversant la couche (30, 40) isolante ou une valeur de mesure de résistance, qui indique la résistance de la couche (30, 40) isolante.

7. Montage (10) suivant l'une des revendications précédentes, **caractérisé en ce que**
   le dispositif (110) de mesure d'un détecteur d'isolation ou comprend aussi un tel détecteur.

8. Montage (10) suivant l'une des revendications précédentes, **caractérisé en ce que**

   - le dispositif (70) de coupure comprend un circuit (80) série ayant un premier interrupteur (S1) et un deuxième interrupteur (S2), qui est monté électriquement entre le boîtier (20) ou la borne (BA) de tension et qui a une borne (90) médiane, et
   - chacune des couches (60) intermédiaires propres à un module est raccordée respectivement à la borne (90) médiane au moyen d'un interrupteur propre à la couche.

9. Montage (10) suivant la revendication 8,
   **caractérisé en ce que**

   - le circuit (80) série a une première résistance (R1) supplémentaire et une deuxième résistance (R2) supplémentaire, et
   - la première résistance (R1) supplémentaire est montée entre la borne (90) médiane et la borne (BA) de tension et la deuxième résistance (R2) supplémentaire est montée entre la borne (90) médiane et le boîtier (20).

10. Montage (10) suivant l'une des revendications précédentes, **caractérisé en ce que**
    la première et la deuxième résistances (R1, R2) supplémentaires ont des valeurs de résistance comprises entre 1 kΩ et 100 kΩ.

11. Montage (10) suivant l'une des revendications précédentes, **caractérisé en ce que**
    le dispositif (100) de commande est constitué,

    - pour le contrôle de la couche (30) intérieure isolante de l'un des modules (BM1-BM3) de tension, fermer le premier interrupteur (S1) et l'interrupteur propre à une couche du module (BM1-BM3) de tension respectif et ouvrir ou faire ouvrir le deuxième interrupteur (S2) et,
    - pour le contrôle de la couche (40) extérieure isolante de l'un des modules (BM1-BM3) de tension, fermer le deuxième interrupteur (S2) et l'interrupteur propre à la couche du module (BM1-BM3) de tension respectif et ouvrir ou faire ouvrir le premier interrupteur (S1).

**12.** Montage (10) suivant l'une des revendications précédentes, **caractérisé en ce que**

- le ou les modules (BM1-BM3) de tension a, en plus de la couche (30) intérieure isolante et la couche (40) extérieure isolante, respectivement d'autres couches isolantes et d'autres couches (60) intermédiaires propres au module et conductrices, et
- le dispositif (70) de coupure a une pluralité d'interrupteurs, qui rendent possible une sélection individuelle de chacune individuellement des couches (30, 40) isolantes de l'un de chacun des modules (BM1-BM3) de tension à des fins de contrôle de la couche (30) isolante respective, à l'aide du dispositif (110) de mesure.

**13.** Montage (10) suivant l'une des revendications précédentes, **caractérisé en ce que**

- le dispositif (25) électrique contient, comme modules (BM1-BM3) de tension, des modules de batterie et forme une batterie,
- le dispositif (25) électrique contient, comme modules (BM1-BM3) de tension, des modules de pile à combustible et forme un dispositif à pile à combustible, ou
- le dispositif (25) électrique contient, comme modules (BM1-BM3) de tension, des modules de batterie et des modules à pile à combustible et forme un dispositif de batterie et à pile à combustible.

**14.** Véhicule, notamment véhicule ferroviaire ayant un montage (10), qui a un boîtier (20) et au moins un module (BM1-BM3) de tension se trouvant dans le boîtier (20),
**caractérisé en ce que**
le montage (10) est un montage (10) suivant l'une des revendications précédentes.

**15.** Procédé pour faire fonctionner un montage (10), qui a un boîtier (20) et au moins un module (BM1-BM3) de tension se trouvant dans le boîtier (20),
dans lequel

- le module (BM1-BM3) de tension a une couche (30) intérieure isolante et une couche (40) extérieure isolante, qui isolent électriquement du boîtier (20) une ou plusieurs cellules (50) contenues dans le module (BM1-BM3) de tension, une couche (60) intermédiaire propre au module et conductrice de l'électricité, étant disposée entre la couche (30) intérieure isolante et la couche (40) extérieure isolante,
- le montage (10) a un dispositif (70) de coupure qui, en fonctionnement de contrôle, peut relier la couche (60) intermédiaire propre au module ou soit au boîtier (20) ou à une borne (BA) de tension, notamment au pôle plus ou au pôle moins du module (BM1-BM3) de tension ou à un dispositif (25) électrique contenant le module (BM1-BM3) de tension,
- au moyen du dispositif (70) de coupure, pour le contrôle de la couche (30) intérieure isolante, on relie la couche (60) intermédiaire propre au module au boîtier (20) et, pour le contrôle de le couche (40) extérieure isolante, on relie la couche (60) intermédiaire propre au module à la borne (BA) de tension,
- pendant le contrôle de la couche (30) intérieure isolante ou de la couche (40) extérieure isolante, on relève une valeur (Mi, Mu, Mu1, Mu2) de mesure, et
- on exploite la au moins une valeur (Mi, Mu, Mu1, Mu2) de mesure et on produit un signal (F) de défaut, si l'exploitation de la valeur de mesure indique un défaut de l'isolation de la couche (30) isolante à contrôler.

FIG 1

FIG 2

FIG 3

FIG 4

FIG 5

400

300

200

100 — ST

Mu1
Mu2

Cz

114
Uz

Rz1

110

Ce

BP
U2

115
Rz2

BA, 25a

25

BM1
30
50
60
40

BM2
30
50
60
40

BM3
30
50
60
40

70

SE1
SE2
SE3

S1
R1
80
90
R2
S2

BP
25b

20

10

**IN DER BESCHREIBUNG AUFGEFÜHRTE DOKUMENTE**

**In der Beschreibung aufgeführte Patentdokumente**

- DE 102014221392
- CN 103048376
- EP 2685541 A